# EUROPEAN PATENT SPECIFICATION

(11) **EP 2 904 886 B1**
(45) Date of publication and mention of the grant of the patent: **01.02.2017**
(21) Application number: 13844514.3
(22) Date of filing: 30.09.2013
(51) Int. Cl.: H05K 7/14, H05K 7/12, F16B 5/12

(54) **PROFILE ELEMENT FOR MOUNTING PCB:S AND PROFILED HOLDER COMPRISING SUCH PROFILE ELEMENT**
PROFILELEMENT ZUR MONTAGE VON PCB:S UND PROFILHALTER MIT SOLCH EINEM PROFILELEMENT
ÉLÉMENT DE PROFIL POUR MONTAGE DE PCB ET SUPPORT PROFILÉ COMPORTANT UN TEL ÉLÉMENT DE PROFIL

(30) Priority: 04.10.2012 SE 1251121
(43) Date of publication of application: 12.08.2015
(73) Proprietor: Ledolight Sweden AB, 441 32 Alingsås (SE)
(72) Inventor: KARLSSON, Dennis, S-441 93 Alingsås (SE)
(74) Representative: Johansson, Lars E.
(86) International application number: PCT/SE2013/051132
(87) International publication number: WO 2014/055012

(56) References cited:
- WO-A1-97/18696
- US-A- 3 975 805
- US-A- 4 751 963
- US-A1- 2010 226 106

## Description

### TECHNICAL FIELD

The present invention relates to a profile element for mounting a printed circuit board and a profiled holder comprising such a profile element.

In particular, the present invention relates to a profile element according to the preamble of claim 1. Such a profile element is known from US 3 975 805 A.

### STATE OF THE ART

The use of printed circuit boards (PCBs) in various applications is known since a long time. The printed circuit boards are mounted flat against the support, usually by screwing the printed circuit boards to the support via holes in the printed circuit board. A ground cable has to be connected to the printed circuit board to enable grounding, resulting in such disadvantages as that the cable could get damaged or come loose from its position. The mounting of printed circuit boards is fiddly and time-consuming, and in addition requires that the printed circuit boards are pre-drilled with holes for the screws in the right place. It is also fiddly and time-consuming to replace the printed circuit boards, should that be necessary, since they are screwed to the support.

### BRIEF DESCTRIPTION OF THE INVENTION

It is a purpose of the present invention to eliminate or at least minimize the above-mentioned problems, and to achieve a simplified process when mounting/removing printed circuit boards, which is achieved by means of a profile element for mounting a printed circuit board, wherein said profile element comprises a slotted profile which comprises two plane-parallel side walls at the inner end thereof forming a mounting slot adapted to surround an edge of a printed circuit board mounted in the mounting slot, wherein said at least one side wall comprises a fixing element for a removable PCB securing means, in the form of a fixing slot, having an extension parallel to said slot.

Owing to the invention, printed circuit boards can be easily and smoothly mounted in and removed from a mounting slot in their applications, without having to drill holes or screw through the actual printed circuit board.

According to another aspect of the invention, the PCB securing means also constitutes means for mounting and removing the printed circuit board in said mounting slot, which offers the advantage that one, and the same component is used for several tasks, which reduces the number of components needed for mounting/removal. Thus, the mounting and removal can be done in a short time period, since the fixing and releasing of the PCB securing means have been integrated into the mounting and removal operation, respectively.

According to yet another aspect of the invention, the fixing slot comprises a semi-circular slot, the opening of which faces inwardly toward said mounting slot, which causes a PCB securing means to engage a printed circuit board placed in the mounting slot.

According to another aspect of the invention, the fixing slot comprises at least one thread-forming element in the form of a ridge inside the fixing slot, which results in the advantage that a PCB securing means can be threaded into the fixing slot.

According to yet another aspect of the invention, the PCB securing means is a screw which can be screwed into the fixing slot, which makes it easy to secure a printed circuit board in its position.

According to another aspect of the invention, the PCB securing means, e.g. the screw, engages one side of the printed circuit board in the vicinity of the opening of the semi-circular slot, when moved into and out of said fixing slot, and furthermore, the PCB securing means acts on the printed circuit board with a frictional force produced at a contact area between the PCB securing means and the printed circuit board, and the frictional force effects an insertion of the printed circuit board into the mounting slot when the PCB securing means is moved into the fixing slot. An ejection of the printed circuit board from the mounting slot is preferably also effected when the PCB securing means is moved out of the fixing slot. Thus, by means of a single component, the PCB securing means (the screw), the insertion/ejection and fixing of the printed circuit board can be achieved without any damage to the actual printed circuit board.

According to yet another aspect of the invention, the mounting slot has such a depth that a ground plane adjacent to the edge of the printed circuit board comes into direct abutment against the PCB securing means, and thus the PCB securing means also constitutes a means for grounding the printed circuit board when it has been mounted in the mounting slot, which means that ground cables can be omitted.

According to another aspect of the invention, the profile element consists of extruded aluminium or other extruded light metal, which makes it simple and inexpensive to manufacture and easy to cut the product to desired lengths and to achieve the desired grounding.

According to yet another aspect of the invention, each of the two side walls have a respective fixing element for the PCB securing means, and the side walls with the fixing elements are mirror-inverted relative to one another, which offers the advantage that, regardless of which way the printed circuit board is turned, a PCB securing means can be used in one of the fixing elements for mounting/removing the printed circuit board and for grounding the printed circuit board.

### BRIEF DESCRIPTION OF THE FIGURES

In the following, the invention will be described in greater detail with reference to the attached figures of the drawings, in which:
Fig. 1 shows a cross-section of a profile element according to the invention;
Fig. 2 shows a cross-section of a profile element according to the invention as an integrated part of a profiled holder for an edge-lit sign;
Fig. 3 shows a profile element according to the invention as an integrated part of a profiled holder with an edge-lit sign;
Fig. 4 shows a perspective view of a profile element according to the invention with a printed circuit board and PCB securing means;
Fig. 5 shows a perspective view of a profile element according to the invention with a printed circuit board and PCB securing means;
Fig. 6 shows a side view of a profile element according to the invention as an integrated part of a profiled holder with an edge-lit sign;
Fig. 7 shows a side view of an alternative embodiment of a profile element according to the invention as an integrated part of a profiled holder; and
Fig. 8 shows a sign with a mounting enclosure according to the invention.

### DETAILED DESCRIPTION OF THE FIGURES

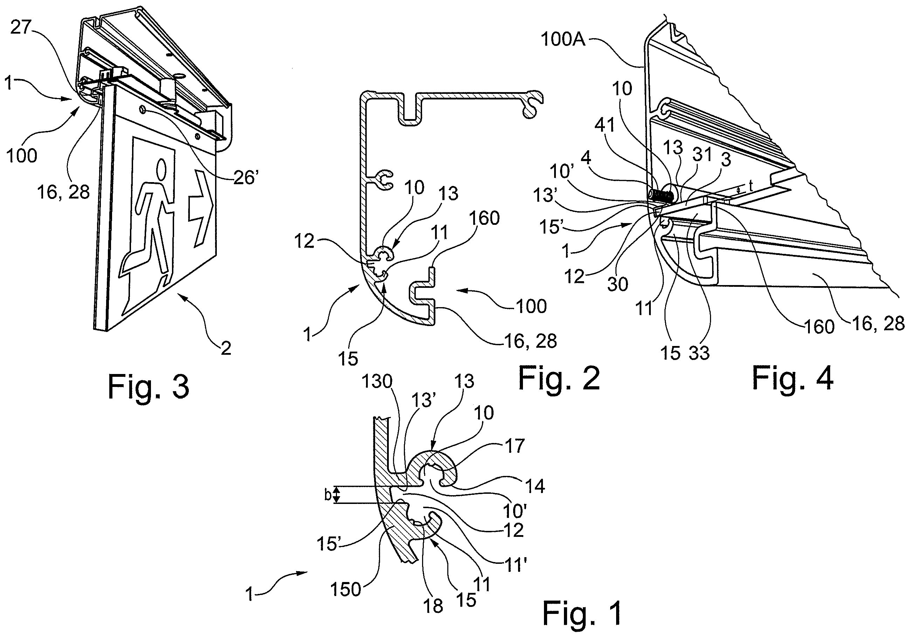

Figure 1 shows a cross-section of a profile element 1 in one embodiment according to the invention, which profile element 1 is intended for the mounting of a printed circuit board 3. The profile element 1 comprises a slotted profile comprising a first 13 and a second 15 opposing profile half, which comprise a first 13' and a second 15' plane-parallel side wall at the inner ends thereof forming a mounting slot 12 adapted to surround an edge 30 (see Figure 4) of a printed circuit board 3 mounted in the mounting slot 12. The mounting slot 12 is provided with a width b, said width b preferably exceeding a thickness t of the printed circuit board 3 intended to be mounted therein.

The profile element 1 preferably consists of extruded aluminium or other extruded light metal. A great advantage of the profile element 1 according to the invention is that it is extruded, which makes it inexpensive and simple to manufacture and enables the extruded sections to be cut to appropriate lengths adapted to the application in question.

At least one side wall 13', 15', preferably both, comprises a fixing element 10, 11 for a removable PCB securing means 4 (see Figure 4), in the form of a fixing slot 10, 11 having an extension parallel to said mounting slot 12. The fixing slot 10, 11 comprises a semi-circular slot 10, 11 comprising an opening 10', 11', which opening faces inwardly toward said mounting slot 12. The fixing slot 10, 11 comprises at least one thread-forming element 17, 18, preferably in the form of a ridge inside the fixing slot 10, 11. Said side walls 13', 15' with fixing slots 10, 11 are mirror-inverted relative to one another, so that the openings 10', 11' face inwardly toward the mounting slot 12.

In the embodiment shown in Figure 1, the profile element is disposed in association with a lower portion of a profiled holder 100 (shown in Figure 2), by means of which the sign can be wall or ceiling mounted. For this purpose, the holder comprises two planar walls disposed at right angles relative to one another. The profile element 1 is placed adjacent to one of the walls where the end of a straight section transitions into a curved section, but this is just a way of exemplifying how it is possible to arrange the profile element 1 and should in no way be seen as limiting for the invention. For production technical reasons, the second profile half 15, which is located at the curved section, has been given a more compact design than the opposing first profile half 13, which is located at the straight section. As seen in the figure, the construction of the walls of the profile element forming the inwardly toward the mounting slot 12 flat side walls 13', 15' is different. For reasons obvious to the skilled person, the second profile half 15 at the curved section has been shortened so that the curved section constituting the exterior wall of the profiled holder 100 and the curved section constituting the wall of the fixing slot 11 form a unit 150. Accordingly, the flat wall section 130, which can be seen on the opposing profile half, is missing. Furthermore, the semi-circular slot 11 of the more compact second profile half 15 has slightly less wrap around, for which reason the two-point support characteristic to the invention, obtained with the first profile half 13, is not achieved, but needs to be solved differently. The principle of two-point supports is described in greater detail in the following.

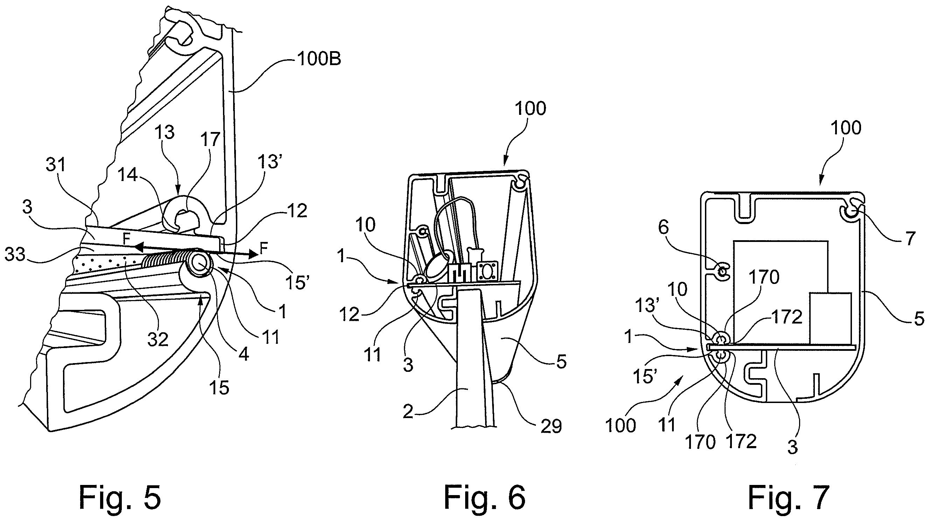

The PCB securing means 4 preferably comprises a screw 4 with threads 41, which screw 4 can be screwed into the fixing slot 10, 11 to secure the printed circuit board. When mounting a printed circuit board 3 in said profile element 1, the printed circuit board 3 is moved a small distance into the mounting slot 12. The printed circuit board 3 comprises a first side 31, a second side 33, and a ground plane 32 disposed at the end of the printed circuit board along the edge 30 on the first side 31 of the printed circuit board. The edge 30 of the printed circuit board is placed in the opening or moved a small distance into the mounting slot 12. The screw 4 is inserted into the fixing slot 10, 11 and, when screwing it into the fixing slot 10, 11, the threads 41 of the screw engage the first side 31 of the printed circuit board (see Figure 4) via the opening 10' 11' of the fixing slot. The screw 4 acts on the printed circuit board 3 with a frictional force F (see Figure 5) produced at a contact area between the threads 41 of the screw and the printed circuit board 3. When the screw 4 is screwed inwardly into the fixing slot 10, 11, the frictional force F effects an insertion of the printed circuit board 3 into the mounting slot 12, at the same time as the screw 4, the further it is screwed into the fixing slot 10, 11, presses against and retains the printed circuit board 3 against the side wall 13', 15' that is opposite to the fixing slot 10, 11 being used. To enable the screw 4 to engage the surface of the printed circuit board 3, it is required that the distance from the fixing slot 10, 11 to the mounting slot 12 is adapted. In this case, the opening 10', 11' of the respective fixing slot is located in the same plane as the respective side wall 13', 15' on the same side. If the screw 4 is unscrewed from the fixing slot 10, 11 instead, the frictional force F produces a counter-force, which ejects the printed circuit board 3 from the mounting slot 12. Thus, the screw 4 also constitutes means for mounting/removal of the printed circuit board 3 in the mounting slot 12.

The opening 10', 11' of the fixing slot is disposed on a level with the ground plane 32 of the printed circuit board 3 so that the PCB securing means 4, in this case the threads 41 of the screw, is in direct abutment against the ground plane 32, and thus also constitutes a means for grounding the printed circuit board 3 when the printed circuit board has been secured in the mounting slot 12. The screw 4 is preferably a self-tapping screw, and when screwing it into the fixing slot 10, 11, threads are formed in the thread-forming elements 17, 18 located inside the fixing slot 10, 11. A further advantage is obtained if the profile element is made of light metal, namely that the formation of threads causes damage to the oxide layer that is normally present on the surface of the light metal, so that the threads 41 of the screw comes into contact with the pure metal beneath the oxide layer, which is a prerequisite for a good electrical grounding between screw 4 and holder 100.

In a preferred embodiment of the profile element 1, it comprises two substantially identical profile halves 170, which are mirror-inverted relative to one another and spaced at a certain distance from one another for the formation of a mounting slot 12, which is shown in Figure 7, and form an outer end of the wall surrounding the semi-circular slot 10, 11 terminated by a planar surface located in the same plane as the respective side wall 13', 15'. The respective abutting surface 172 cooperates with a respective side wall 13', 15' on the same side and provides a two-point support for the printed circuit board 3 characteristic to the invention, as the PCB securing means 4 acts on the opposite side of the printed circuit board, wherein the printed circuit board 3 is given a firm anchorage and a correct positioning. This two-point principle is also achieved by the profile half 13 that is located at the straight section of the profiled holder 100 in the embodiment shown in Figure 1. Thus, the two-point support is achieved by means of the side wall 13' and a first abutting surface 14 of the first profile half 13. The opposing profile half 15 in Figure 1, on the other hand, does not provide this two-point support due to the selection of a different solution, described below with reference to Figure 2.

Figure 2 shows, in cross-section, an example of how a profile element 1 has been integrated into a profiled holder 100. The two-point support for the profile half 15 disposed at the curved section of the holder 100 is achieved in that the curved section comprises at its lower portion a support wall 16 extending upwardly in parallel with the wall of the straight section of the holder 100, at which the profile element 1 is disposed and located such that the mounting slot 12 extends perpendicularly from the wall of this straight section. At its upper end, the support wall 16 is terminated by a third abutting surface 160, which is located in the same plane as the side wall 15' on the same side of the mounting slot 12. When the printed circuit board 3 is mounted in the profile element 1 and the screw presses the printed circuit board 3 against the opposing side wall 15 (see Figure 4), the printed circuit board 3 is also pressed against said abutting surface 160 and thus a stable mounting thereof is obtained.

Figure 4 shows a perspective view of a profile element 1 as an integrated part of a profiled holder 100, where the printed circuit board 3 has been moved into the mounting slot 12 and the screw 4 is partially screwed into the upper semi-circular fixing slot 10. The figure shows the first short side 100A of the profiled holder. Here, it is also clearly seen how the printed circuit board 3 is pressed against the opposing second side wall 15'and the third abutting surface 160 on the support wall 16. If, on the other hand, the ground plane 32 of the printed circuit board were disposed on the second side 33 of the printed circuit board, the opposing fixing slot 11 of the profile element would have been used instead, and in that case the screw 4 had been screwed in from the other short side 100B of the holder 100 (see Figure 5) so as to cause an insertion of the printed circuit board 3 into the mounting slot 12 when the screw 4 is screwed into the slot 11. When the printed circuit board 3 is mounted in the slot 11 from the other short side 100B, the screw 4 presses the printed circuit board 3 against the opposing side wall 13' and the abutting surface 14 and thus a stable fixation is obtained. Since the profile element 1 comprises profile halves 13, 14 with fixing slots 10, 11 facing inwardly toward the mounting slot 12, it doesn't matter on which side of the printed circuit board 3 the ground plane 32 is, but the appropriate fixing slot 10, 11 for the application in question is used. Irrespective of whether the profile halves have the same height or not, the advantage is obtained that the PCB securing means 4 can be screwed to the profiled holder 100 from either side, depending on which side of the printed circuit board 3 the ground plane 32 is located on.

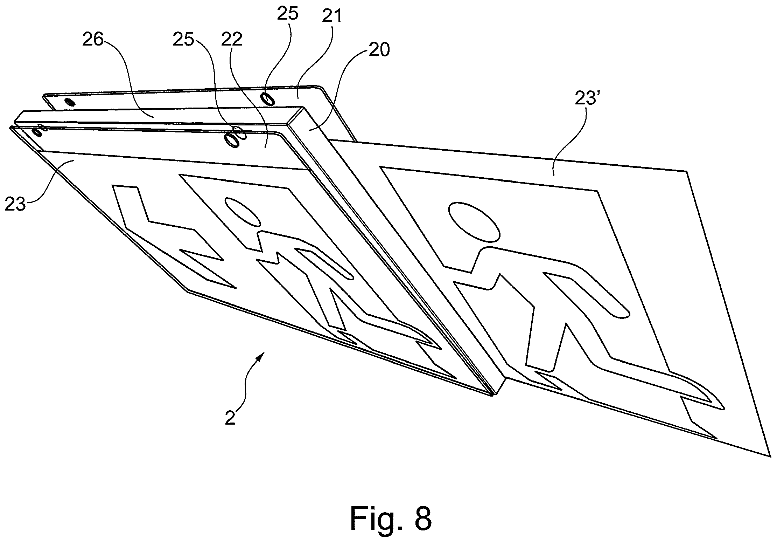

Fig. 8 shows a sign 2 with a mounting enclosure 21, 22 according to the invention. The sign 2 comprises a light-scattering panel 20, which is intended to be edge-lit and thus to provide a background lighting for a message applied to one side of the light-scattering panel 20. In this case, an acrylic panel 20 is used, but other light-scattering materials meeting the purpose, such as ground glass, can of course be used. Edge-lit signs are previously known and the technique will therefore not be described in greater detail.

The invention relates to a simple method of removably applying the figures/images on the acrylic panel 20 which is to be background lit. The mounting enclosure 21, 22 is adapted to longitudinally at least partially, but preferably completely, surround the front side, back side and bottom side of the acrylic panel 20 that is edge-lit. In the transverse direction, the mounting enclosure 21, 22 extends from the upper edge of the front side of the illuminated sign, around the bottom edge, and further upward along the back side back to the upper edge. A much thinner panel 23 of a transparent material with a translucent image/message, which will thus be illuminated from the back, is applied to the front side thereof. A likewise thin panel 23' having a reflecting surface is applied to the back side thereof, as an alternative with the same image/message as on the front side, but mirror-inverted, if the sign is to be viewed from two directions. The mounting enclosure 21, 22 is made of a transparent material providing a certain flexibility or resiliency. The mounting enclosure 21, 22 is preferably made in one piece. Suitably, use is made of a flat panel of thermoplastic which, when formed into a U shaped pocket, has a distance between the two opposing walls which at least corresponds to the total thickness of the light-scattering panel 20 and the two thinner image-carrying panels 23, 23'. The image-carrying panels are most easily applied to the sides of the plexiglass panel 20 before the sign is mounted in the holder 100. By slightly bending out the respective sides 21, 22 of the mounting enclosure 21, 22, separately, or simultaneously if this is found suitable, the existing gap on either side of the light-scattering panel 20 and the mounting enclosure 21, 22 is widened, wherein the image-carrying panels 23, 23' easily can be slid into the respective gap. Naturally, several panels per side can be used, e.g. disposed side by side, to produce the desired message. The light-scattering panels 20 and the mounting enclosure 21, 22 comprise some kind of fixing devices, here through-holes 25 along the upper edge 26, into which anchoring means 26', for example screws, plugs or pins, can be inserted for anchorage in a profiled holder 100.

Figure 3 shows a profile element 1 according to the invention as an integrated part of a profiled holder 100 with an edge-lit sign 2. Here, the profiled holder is mounted on a wall, and the sign 2, comprising the mounting enclosure 21, 22 according to the invention and thin panel 23 with a message applied therein, has been mounted in the holder such that it hangs down vertically from the holder. The sign 2 is anchored in an anchor slot 27 in the holder 100 via a pair of screws 26 which have been inserted into the holes 25, but instead of screws, protruding pins which are anchored in the anchor slot can be used, whereupon the sign is suspended from these pins. The anchor slot 27 is formed in the support wall 16 in the lower portion of the holder, against the flat surface 28 of which the upper portion of the back side of the sign 2 abuts. Accordingly, the flat surface 28 constitutes a counter support which, in cooperation with the lower end of a front cover 5 (shown in Figure 6) and two end covers 29 disposed at each side of the holder 100, secures the sign 2 in the holder. The lower end of the front cover 5 abuts against the front side of the sign 2 on the opposite side of the flat surface 28. For aesthetic reasons, the front cover hides the anchor slot 7 and its anchoring means 26, and preferably the major part of, or the entire flat surface 28 is hidden.

In the figure, an end cover 29 at the far end of the holder 100 can be seen, but it should be understood that the end covers are mounted after having mounted the front cover 5, since the end covers 29 are adapted to surround the edges of the short sides of the holder 100 and the front cover 5 and secure them relative to each other. The end covers 29 are secured to the holder 100 by screwing into a screw receiver 6 of a conventional type at the back wall of the holder. The holder 100 further comprises means mounted therein for illuminating an upper edge of the plexiglass panel and electronic components for controlling and regulating these means.

A side view of a profiled holder 100 with an edge-lit sign 2 and a front cover 5 mounted on the open side of the profiled holder 100 is seen in Figure 6. At the back end, it can be seen how the end of the front cover 5 has been surrounded by an end cover 29 and secured in its position relative to the holder 100. At the open front end of the holder 100, it can be seen how the front cover 5 and the flat surface 28 of the support wall 16 of the holder 100 cooperate to secure the sign 2 in the holder 100. Changing messages on signs provided with a mounting enclosure 21, 22 according to the invention is very easy and goes quickly. By loosening the end covers at each end of the holder 100, the front cover 5 can be angled upward via the hinge device 7 disposed at the upper end. The sign 2 can then be loosened slightly from the anchoring devices, and the sides of the mounting enclosure 21, 22 can be bent outward a little so that the thin panels 23, 23' can be slid laterally out of the slots and be replaced by new ones in the reverse way. Owing to the fact that the mounting enclosure 21, 22 is flexible, also a change of message without previously opening the holder according to the above description is enabled. Depending on the width of the respective gap inside the sides of the mounting enclosure, the thin panel 23 with the message can be retained by a certain clamping force, if desired. This may make it necessary to use some form of tool to pry out the thin panel with the message placed inside the slot a small distance to make it accessible on the opposite side, alternatively to grab a hold of it to pull it out. The access to the thin image-carrying panel is made easier if the mounting enclosure 21, 22 does not cover the entire light-scattering panel 20.

The invention is not limited to what has been described above, but can be varied within the scope of the following claims. For instance, it is appreciated that the profile element 1 may comprise only one profile half with fixing slots cooperating with some kind of opposing abutting surface, which together form two plane-parallel side walls forming a mounting slot for the printed circuit board. Furthermore, it is appreciated that the fixing slot may have other shapes. For example, the fixing slot could be in the shape of a triangle, wherein a triangular plug is pressed into the slot and one edge of the plug is brought into contact with the ground plane via the opening of the fixing slot facing the printed circuit board. In that case, the plug provides grounding for the printed circuit board and presses the board against the opposing side and holds it in place. Electrical contact can be ensured by pretreating the inside of the fixing slot in order to remove the oxide layer. Likewise a plug which has been provided with some kind of protruding tip or shoulder extending in a downwardly sloping line along the side of the plug, on the side facing the printed circuit board, can be used. This tip/shoulder engages the printed circuit board, and when inserting the plug, the printed circuit board is pressed downwardly in the slot and takes care of the grounding. If the profile element 1 is made of electrically non-conducting material, e.g. plastic, the fixing slot can be provided with a metal socket for grounding. Likewise, it is appreciated that grounding can be achieved by connecting a cord to the screw in a conventional way, but that despite this the other advantages characteristic to the invention are achieved.

## Claims

1. A profile element (1) for mounting a printed circuit board (3), wherein said profile element (1) comprises a slotted profile (13, 15) comprising at least one profile half (13, 15), said slotted profile (13, 15) comprising two plane-parallel side walls (13', 15') at the inner end thereof forming a mounting slot (12) adapted to surround an edge (30) of a printed circuit board (3) mounted in the mounting slot (12), wherein said at least one side wall (13', 15') comprises a fixing element (10, 11) in the form of a fixing slot (10, 11) for a PCB securing means (4), said fixing slot (10, 11) having an extension parallel to said mounting slot (12), **characterized in that** said PCB securing means (4) is removably disposed, so as to effect a mounting and fixing of said printed circuit board (3) in the mounting slot (12) when mounted in the fixing slot (10, 11), and to effect a removal of said printed circuit board (3) from the mounting slot (12) when removed from the fixing slot (10, 11), the PCB securing means (4) thus also constituting means for mounting and removal of said printed circuit board (3) in said mounting slot (12).

2. The profile element (1) according to claim 1, **characterized i**n that said mounting slot (12) is provided with a width (b) exceeding the thickness (t) of the printed circuit board (3) intended to be mounted therein.

3. The profile element (1) according to claim 1, **characterized i**n that said fixing slot (10, 11) comprises a semi-circular slot (10, 11), the opening (10', 11') of which faces inwardly toward said mounting slot (12).

4. The profile element (1) according to claim 3, **characterized in that** said fixing slot (10, 11) comprises at least one thread-forming element (17, 18) in the form of a ridge inside the fixing slot (10, 11).

5. The profile element (1) according to claim 4, **characterized i**n that said PCB securing means (4) is a screw (4) which can be screwed into the fixing slot (10, 11).

6. The profile element (1) according to claim 5, **characterized in that** said PCB securing means (4), when inserted into said fixing slot (10, 11), is adapted to engage a side (31, 33) of the printed circuit board (3) in the vicinity of said opening (10', 11') of the semi-circular slot (10, 11), and is furthermore adapted to act on said printed circuit board (3) with a frictional force (F) produced at a contact area between the PCB securing means (4) and the printed circuit board (3), wherein said frictional force (F) effects an insertion of the printed circuit board (3) into the mounting slot (12) when the PCB securing means (4) is moved into the fixing slot (13, 15), and preferably also effects an ejection of the printed circuit board (3) from the mounting slot (12) when the PCB securing means (4) is moved out of the fixing slot (13, 15).

7. The profile element (1) according to claim 1, **characterized in that** said mounting slot (12) has a depth adapted to said circuit board (3) so that a ground plane (32) adjacent to said edge (30) of the printed circuit board (3) is surrounded by said side wall (13, 15) provided with fixing elements when the printed circuit board (3) has been mounted in the mounting slot (12).

8. The profile element (1) according to claim 7, **characterized i**n that the position of said fixing element (10, 11) is adapted to said ground plane (32) of the printed circuit board (3) so that said PCB securing means (4) is in direct abutment against the ground plane (32) and also constitutes a means for grounding said printed circuit board (3) when said printed circuit board has been mounted in the mounting slot (12).

9. The profile element (1) according to claim 3, **characterized in that** it consists of extruded aluminium or other extruded light metal.

10. The profile element (1) according to claim 1, **characterized in that** each of the two profile halves (13, 15) comprises a respective fixing element (10, 11) for said PCB securing means (4).

11. The profile element (1) according to claim 10, **characterized in that** the profile halves (13, 15) are mirror-inverted relative to one another.

12. A profiled holder (100) for an edge-lit sign (2), preferably an edge-lit emergency lighting, **characterized in that** it comprises a profile element (1) according to any one of the claims 1-11.

## Patentansprüche

1. Profilelement (1) zum Montieren einer Leiterplatte (3), wobei das Profilelement (1) ein geschlitztes Profil (13, 15) umfasst, das mindestens eine Profilhälfte (13, 15) umfasst, wobei das geschlitzte Profil (13, 15) zwei planparallele Seitenwände (13', 15') an dem inneren Ende davon umfasst, die einen Montageschlitz (12) formen, der angepasst ist, eine Kante (30) einer Leiterplatte (3) zu umgeben, die in dem Montageschlitz (12) montiert ist, wobei die mindestens eine Seitenwand (13', 15') ein Fixierelement (10, 11) in der Form eines Fixierschlitzes (10, 11) für ein PCB-Befestigungsmittel (4) umfasst, wobei der Fixierschlitz (10,11) eine Ausdehnung parallel zu dem Montageschlitz (12) aufweist, **dadurch gekennzeichnet, dass** das PCB-Befestigungsmittel (4) entfernbar angeordnet ist, um so ein Montieren und Fixieren der Leiterplatte (3) in dem Montageschlitz (12) zu bewirken, wenn sie in dem Fixierschlitz (10, 11) montiert wird, und um ein Entfernen der Leiterplatte (3) aus dem Montageschlitz (12) zu bewirken, wenn sie aus dem Fixierschlitz (10, 11) entfernt wird, somit bildet das PCB-Befestigungsmittel (4) auch ein Mittel zum Montieren und Entfernen der Leiterplatte (3) in dem Montageschlitz (12).

2. Profilelement (1) gemäß Anspruch 1, **dadurch gekennzeichnet, dass** der Montageschlitz (12) mit einer Breite (b) bereitgestellt wird, die die Dicke (t) der Leiterplatte (3), die darin montiert werden soll, übersteigt.

3. Profilelement (1) gemäß Anspruch 1, **dadurch gekennzeichnet, dass** der Fixierschlitz (10, 11) einen halbkreisförmigen Schlitz (10, 11) umfasst, dessen Öffnung (10', 11') nach innen in Richtung des Montageschlitzes (12) gewandt ist.

4. Profilelement (1) gemäß Anspruch 3, **dadurch gekennzeichnet, dass** der Fixierschlitz (10,11) mindestens ein gewindeformendes Element (17, 18) in der Form einer Rippe innerhalb des Fixierschlitzes (10, 11) umfasst.

5. Profilelement (1) gemäß Anspruch 4, **dadurch gekennzeichnet, dass** das PCB-Befestigungsmittel (4) eine Schraube (4) ist, welche in den Fixierschlitz (10, 11) geschraubt werden kann.

6. Profilelement (1) gemäß Anspruch 5, **dadurch gekennzeichnet, dass** das PCB-Befestigungsmittel (4), wenn es in den Fixierschlitz (10, 11) eingesetzt ist, angepasst ist, in der Nähe der Öffnung (10', 11') des halbkreisförmigen Schlitzes (10, 11) mit einer Seite (31, 33) der Leiterplatte (3) in Eingriff zu stehen, und weiterhin angepasst ist, auf die Leiterplatte (3) mit einer Reibungskraft (F) zu wirken, die an einem Kontaktbereich zwischen dem PCB-Befestigungsmittel (4) und der Leiterplatte (3) erzeugt wird, wobei die Reibungskraft (F) ein Einsetzen der Leiterplatte (3) in den Montageschlitz (12) bewirkt, wenn das PCB-Befestigungsmittel (4) in den Fixierschlitz (13, 15) bewegt wird, und bevorzugt auch ein Auswerfen der Leiterplatte (3) aus dem Montageschlitz (12) bewirkt, wenn das PCB-Befestigungsmittel (4) aus dem Fixierschlitz (13, 15) bewegt wird.

7. Profilelement (1) gemäß Anspruch 1, **dadurch gekennzeichnet, dass** der Montageschlitz (12) eine Tiefe aufweist, die an die Leiterplatte (3) angepasst ist, so dass eine Erdungsfläche (32) benachbart der Kante (30) der Leiterplatte (3) von der Seitenwand (13, 15) umgeben ist, die mit Fixierelementen versehen ist, wenn die Leiterplatte (3) in dem Montageschlitz (12) montiert worden ist.

8. Profilelement (1) gemäß Anspruch 7, **dadurch gekennzeichnet, dass** die Position des Fixierelements (10, 11) an die Erdungsfläche (32) der Leiterplatte (3) angepasst ist, so dass das PCB-Befestigungsmittel (4) direkt gegen die Erdungsfläche (32) anliegt und auch ein Mittel zum Erden der Leiterplatte (3) bildet, wenn die Leiterplatte in dem Montageschlitz (12) montiert worden ist.

9. Profilelement (1) gemäß Anspruch 3, **dadurch gekennzeichnet, dass** es aus stranggepresstem Aluminium oder anderem stranggepressten Leichtmetall besteht.

10. Profilelement (1) gemäß Anspruch 1, **dadurch gekennzeichnet, dass** jede der zwei Profilhälften (13, 15) ein jeweiliges Fixierelement (10, 11) für das PCB-Befestigungsmittel (4) umfasst.

11. Profilelement (1) gemäß Anspruch 10, **dadurch gekennzeichnet, dass** die Profilhälften (13, 15) relativ zueinander spiegelbildlich sind.

12. Profilierte Halterung (100) für ein kantenbeleuchtetes Zeichen (2), bevorzugt eine kantenbeleuchtete Notbeleuchtung, **dadurch gekennzeichnet, dass** sie ein Profilelement (1) gemäß irgendeinem der Ansprüche 1-11 umfasst.

## Revendications

1. Un élément profilé (1) destiné à monter une carte à circuit imprimé (3), dans lequel ledit élément de profil (1) comprend un profil fendu (13, 15) comprenant au moins une moitié profilée (13, 15), ledit profil fendu (13, 15) comprenant deux parois latérales (13', 15') planes et parallèles formant une fente de montage (12) adaptée pour entourer un bord (30) d'une carte à circuit imprimé (3) montée dans la fente de montage (12), dans lequel ladite au moins une paroi latérale (13', 15') comprend un élément de fixation (10, 11) sous la forme d'une fente de fixation (10, 11) pour un moyen (4) de fixation de carte à circuit imprimé, ladite fente de fixation (10, 11) ayant une extension parallèle à ladite fente de montage (12), **caractérisé en ce que** lesdits moyens (4) de fixation de carte à circuit imprimé sont disposés de manière amovible, de façon à effectuer un montage et une fixation de ladite carte à circuit imprimé dans la fente de montage (12) lorsqu'elle est montée dans la fente de fixation (10, 11), et pour retirer ladite carte à circuit imprimé (3) de la fente de montage (12) lorsqu'elle est retirée de la fente de fixation (10, 11), les moyens (4) de fixation de carte à circuit imprimé constituant ainsi également des moyens de montage et de retrait de ladite carte à circuit imprimé (3) dans ladite fente de montage (12).

2. L'élément profilé (1) selon la revendication 1, **caractérisé en ce que** ladite fente de montage (12) a une largeur (b) supérieure à l'épaisseur (t) de la carte imprimée (3) destinée à être montée à l'intérieur d'elle.

3. L'élément profilé (1) selon la revendication 1, **caractérisé en ce que** ladite fente de fixation (10, 11) comprend une fente semi-circulaire (10, 11) dont l'ouverture (10', 11') est tournée vers l'intérieur en direction de Ladite fente de montage (12).

4. L'élément profilé (1) selon la revendication 3, **caractérisé en ce que** ladite fente de fixation (10, 11) comprend au moins un élément (17, 18) de formation de filetage sous forme d'une arête située à l'intérieur de la fente de fixation (10, 11).

5. L'élément profilé (1) selon la revendication 4, **caractérisé en ce que** ledit moyen de fixation (4) de carte à circuit imprimé est une vis (4) apte à être vissée dans la fente de fixation (10, 11).

6. L'élément profilé (1) selon la revendication 5, **caractérisé en ce que** lesdits moyens de fixation (4) de la carte à circuit imprimé, lorsqu'ils sont insérés dans ladite fente de fixation (10, 11), sont adaptés pour venir en engagement avec un côté (31, 33) de la carte à circuit imprimé (3) à proximité de ladite ouverture (10', 11') de la fente semi-circulaire (10, 11), et sont en outre adaptés pour agir sur ladite carte à circuit imprimé (3) avec une force de frottement (F) produite au niveau d'une zone de contact entre les moyens (4) de fixation de la carte à circuit imprimé et la carte à circuit imprimé (3), ladite force de friction (F) effectuant une insertion de la carte à circuit imprimé (3) dans la fente de montage (12) lorsque les moyens de fixation (4) sont déplacés dans la fente de fixation (13, 15), et effectue de préférence également une éjection de la carte à circuit imprimé (3) hors de la fente de montage (12) lorsque les moyens (4) de fixation de la carte à circuit imprimé sont déplacés hors de la fente de fixation (13, 15).

7. L'élément profilé (1) selon la revendication 1, **caractérisé en ce que** ladite fente de montage (12) présente une profondeur adaptée à ladite carte à circuit imprimé (3) de sorte qu'un plan de masse (32) adjacent audit bord (30) de la carte à circuit imprimé (3) est entourée par ladite paroi latérale (13, 15) pourvue d'éléments de fixation lorsque la carte à circuit imprimé (3) a été montée dans la fente de montage (12).

8. L'élément profilé (1) selon la revendication 7, **caractérisé en ce que** la position dudit élément de fixation (10, 11) est adaptée audit plan de masse (32) de la carte à circuit imprimé (3) de sorte que lesdits moyens (4) de fixation de carte à circuit imprimé sont en butée directe contre le plan de masse (32) et constituent également un moyen pour mettre à la terre ladite carte à circuit imprimé (3) lorsque ladite carte à circuit imprimé a été montée dans la fente de montage (12).

9. L'élément profilé (1) selon la revendication 3, **caractérisé en ce qu'**il est constitué d'aluminium extrudé ou d'un autre métal léger extrudé.

10. L'élément profilé (1) selon la revendication 1, **caractérisé en ce que** chacune des deux moitiés de profil (13, 15) comprend un élément de fixation respectif (10, 11) pour lesdits moyens de fixation (4) de carte à circuit imprimé.

11. L'élément profilé (1) selon la revendication 10, **caractérisé en ce que** les moitiés de profil (13, 15) sont inversées en miroir l'une par rapport à l'autre.

12. Support profilé (100) pour un panneau (2) éclairé par la tranche, de préférence un éclairage de secours éclairé par la tranche, **caractérisé en ce qu'**il comprend un élément profilé (1) selon l'une quelconque des revendications 1 à 11.
